Europäisches Patentamt

European Patent Office

Office européen des brevets

(19)

(11) Publication number: **0 035 379**

**B1**

(12) **EUROPEAN PATENT SPECIFICATION**

(45) Date of publication of patent specification: **27.06.84**

(51) Int. Cl.³: **H 02 M 1/08, H 03 K 17/72**

(21) Application number: **81300812.5**

(22) Date of filing: **26.02.81**

(54) A gate circuit for a thyristor and a thyristor having such a gate circuit.

(30) Priority: **28.02.80 JP 24849/80**

(43) Date of publication of application:
**09.09.81 Bulletin 81/36**

(45) Publication of the grant of the patent:
**27.06.84 Bulletin 84/26**

(84) Designated Contracting States:
**DE GB**

(56) References cited:
**DD - A - 51 927**
**DE - A - 2 951 115**
**DE - A - 3 015 198**
**DE - B - 2 062 814**
**US - A - 3 728 557**
**US - A - 3 781 572**

(73) Proprietor: **Hitachi, Ltd.**
**5-1, Marunouchi 1-chome**
**Chiyoda-ku Tokyo 100 (JP)**

(72) Inventor: **Fukui, Hiroshi**
**1047-253 Moriyamacho**
**Hitachi-shi (JP)**
Inventor: **Kimura, Shin**
**1404-7 Ishinazakacho**
**Hitachi-shi (JP)**
Inventor: **Onda, Kenichi**
**161-424 Ishinazakacho**
**Hitachi-shi (JP)**
Inventor: **Amano, Hisao**
**336-18 Kijicho**
**Hitachi-shi (JP)**

(74) Representative: **Paget, Hugh Charles Edward et al,**
**MEWBURN ELLIS & CO. 2/3 Cursitor Street**
**London EC4A 1BQ (GB)**

Courier Press, Leamington Spa, England.

## Description

This invention relates to a gate circuit for a thyristor and in particular, a gate circuit of the type which employs a narrow or short duration pulse for turning on the gate of a thyristor (hereinafter referred to as narrow gate-on pulse gate circuit).

Usually, a gate circuit of the type which employs a wide pulse for turning on the gate of a thyristor (hereinafter referred to as wide gate-on pulse gate circuit) is used for a motor driving inverter because, when the inverter is connected to a load having a lagging power factor and hence thyristors forming the inverter are subjected to lagging voltages, the narrow gate-on pulse gate circuit tends to fail to switch-on the thyristors. However, with the wide gate-on pulse gate circuit by which the thyristor is turned on during the duration of the gate-on signal, the time of conduction of the gate current is rather long. Consequently, a large power consumption occurs in the gate and the cost of the gate circuit rises. It has been suggested that a narrow gate-on pulse gate circuit should be used so that a narrow pulse is applied to the gate of the thyristor when forward voltage across the anode and cathode of the thyristor is detected. This circuit can reduce the conduction time of the gate current and minimise power consumption in the gate. The narrow gate-on pulse with a pulse width of about several microseconds, identical to the turn-on time of the thyristor, is actually sufficient to turn on the gate. In a narrow gate-on pulse gate circuit used conventionally, however, it is usual to apply a narrow gate signal having a pulse width of several tens of microseconds to the gate, due to the need to achieve turn-on of the thyristor, because the turn-on times of thyristors vary because of irregularity in the circuit elements and in the conditions for conduction. Accordingly, in the conventional narrow gate-on pulse gate circuit, a gate signal having an unnecessarily wide pulse width is applied to the gate and excessive power consumption occurs.

The present invention therefore seeks to provide a gate circuit for thyristors according to the pre-characterising portion of claim 1 which can reduce the conduction time of the gate-on current applied to the thyristor.

The present invention is defined in the claims. In the circuit of the invention, the switch-on signal making the switching circuit conductive is by-passed through the diode into the anode of the thyristor, when the thyristor is turned on. Therefore, the switch-on signal is no longer applied to the switching circuit, thus making the switching circuit non-conductive. As a result, the time of conduction of the gate current of the thyristor is reduced to the minimum.

Thus, the invention can achieve the provision of a gate circuit which minimizes power consumption in the gate.

Embodiments of the invention will now be described by way of example with reference to the accompanying drawings in which:—

Fig. 1 is a circuit diagram of a gate circuit embodying the invention; and

Fig. 2 is a circuit diagram showing another embodiment of the invention.

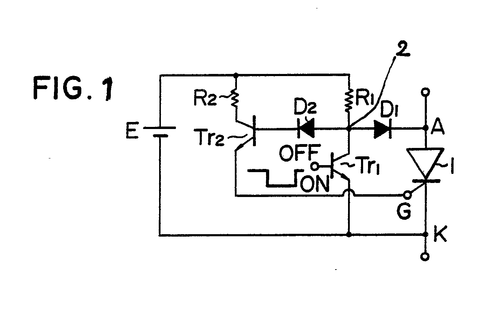

In the circuit of Fig. 1 an anode A of a thyristor 1 is connected to a cathode of a diode $D_1$. The diode $D_1$ has its anode connected to a power supply E for the gate-on current via a resistor $R_1$, to an anode of a diode $D_2$, and to a collector of a transistor $Tr_1$. The diode $D_2$ has its cathode connected to a base of a transistor $Tr_2$. This transistor $Tr_2$ has its collector connected to the power supply E via a resistor $R_2$ and its emitter connected to the gate G of the thyristor 1. The transistor $Tr_1$ has its emitter connected to the cathode K of the thyristor 1 which is connected to the power supply E. A gate ignition signal from a gate ignition signal generator circuit (not shown) is applied to the base of the transistor $Tr_1$. The switch-on signal for making the transistor $Tr_2$ conductive is applied to a junction 2.

With this construction, when the thyristor 1 is turned off with forward voltage blocked, a reverse voltage is applied across the diode $D_1$. When the switch-off signal (negative) is applied to the transistor $Tr_1$ to turn it off, base current (the switch-on signal) flows into the transistor $Tr_2$ via the resistor $R_1$. The transistor $Tr_2$ is then turned on to allow switch-on current flow through a path

$$\text{"E-}R_2\text{-}Tr_2\text{-G-1-K-E".}$$

When the thyristor 1 is turned on and the anode voltage drops, the transistor $Tr_2$ is turned off, because the switch-on signal by-passes a path 2-$D_1$-A. In other words, the supply of gate current is interrupted.

In this way, it is possible to minimize power consumption by detecting the anode-cathode voltage of the thyristor 1 and thus the anode voltage drop, and turning off the gate current accordingly.

This embodiment is also advantageous in that no misfiring occurs even with a load having a lagging power factor.

Furthermore, since, in this embodiment, delivery of gate current to the thyristor is determined by the anode voltage of the thyristor, the pulse width of the gate current is reduced nearly to the time necessary for turning on the thyristor, thus minimizing power consumption.

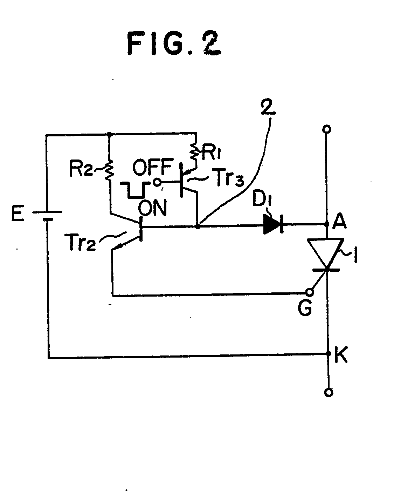

Turning to the circuit of Fig. 2, an anode A of a thyristor 1 is connected to the cathode of a diode $D_1$. The diode $D_1$ has its anode connected to a collector of a transistor $Tr_3$ and to a base of a transistor $Tr_2$. The transistor $Tr_2$ has its collector connected to the power supply E via a resistor $R_2$ and its emitter connected to the gate G of the thyristor 1. The transistor $Tr_3$ has its emitter connected to the power supply E via a resistor

$R_1$. The base of the transistor $Tr_3$ receives the switch-on signal from a switch-on signal generator circuit (not shown).

With this construction, when the thyristor 1 is turned off with forward voltage blocked, a reverse voltage is applied across the diode $D_1$. When the switch-on signal (negative) is applied to the transistor $Tr_3$ to turn it on, base current (the switch-on signal) flows into the transistor $Tr_2$ via the resistor $R_1$. The transistor $Tr_2$ is then turned on to allow gate-on current flow through a path

"E-$R_2$-$Tr_2$-G-1-K-E".

When the thyristor 1 is turned on and the anode voltage drops, the transistor $Tr_2$ is turned off, because the switch-on signal by-passes a path 2-$D_1$-A. In other words, the supply of gate current is interrupted.

This embodiment thus achieves the same effect as the previous embodiment.

While the foregoing embodiments illustrate gate circuits of thyristors which are turned on by gate current, the invention may also be applied to a gate turn-off thyristor in which anode current can be interrupted by gate current. The gate turn-off thyristor has a minimum switch-on current which is larger than that of the illustrated thyristors. Accordingly, the effect of reducing power consumption in the gate circuit of a gate turn-off thyristor by the use of a narrow pulse is considerable.

For example, let I, E, $T_{ON}$ and T be the minimum switch-on current, the gate-on voltage, the gate current conduction time, and one time period, respectively. Then, the power consumption P in the gate circuit is expressed as:—

$$P = I \times E \times T_{ON}/T$$

For a narrow pulse, $T_{ON}$ is a few microseconds. Accordingly, if it is assumed that the conduction ratio is 50% at 1 KHz and $T_{ON}$=500 $\mu$s for a wide pulse the power consumption in the gate circuit can be reduced by about 1/20 by replacing the wide gate-on pulse gate circuit with the narrow gate-on pulse gate circuit according to the invention.

## Claims

1. A gate circuit for a thyristor comprising a power supply (E) for feeding gate-on current through a gate and cathode of the thyristor (1) and a switching circuit ($Tr_2$) connected in series with the power supply (E) to turn the gate-on current on or off, characterized in that a diode ($D_1$) is connected between a switch-on signal input terminal (2) of said switching circuit ($Tr_2$) and the anode of said thyristor (1) with the forward direction of the diode ($D_1$) towards the anode of the thyristor (1) in order to make said switching circuit ($Tr_2$) non-conductive when the thyristor (1) has been turned on by the gate-on current.

2. A gate circuit according to claim 1, wherein said switching circuit is a transistor ($Tr_2$) whose emitter is connected to the gate of said thyristor (1), whose collector is connected to a positive terminal of said power supply (E) and whose base is connected to said switch-on signal input terminal (2).

3. A gate circuit according to claim 2, further comprising a switching element ($Tr_1$) connected between the cathode of said thyristor (1) and said turn-on signal input terminal (2), said switching element ($Tr_1$) being turned on or off by the gate ignition signal, and there being a resistor ($R_1$) connected between the positive terminal of said power supply (E) and said switch-on signal input terminal (2).

4. A gate circuit according to claim 2, further comprising a series circuit in which a switching element ($Tr_3$) is connected in series with a resistor ($R_1$), said series circuit being disposed between the positive terminal of said power supply (E) and said switch-on signal input terminal (2), said switching element ($Tr_3$) being turned on or off by the gate ignition signal.

5. A thyristor having a gate circuit according to any one of the preceding claims.

6. A thyristor according to claim 5 which is a gate turn-off thyristor.

## Patentansprüche

1. Schaltung zur Gateaussteuerung für einen Thyristor mit einer Spannungsversorgung (E), um einen Toreinschlatstrom über das Tor und die Kathode des Thyristors (1) zuzuführen, und mit einem Schalter-Kreis ($Tr_2$), der in Reihe mit der Spannungsversorgung (E) geschaltet ist, um den Toreinschaltstrom an- oder abzuschalten, dadurch gekennzeichnet, daß eine Diode ($D_1$) zwischen einen Einschaltsignal-Eingangsanschluß (2) des Schalter-Kreises ($Tr_2$) und die Anode des Thyristors (1) geschaltet ist, wobei die Vorwärtsrichtung der Diode ($D_1$) zur Anode des Thyristors (1) zeigt, um den Schalter-Kreis ($Tr_2$) nicht-leitend zu machen, wenn der Thyristor (1) durch den Toreinschaltstrom eingeschaltet worden ist.

2. Schaltung nach Anspruch 1, bei der der Schalter-Kreis ein Transistor ($Tr_2$) ist, dessen Emitter mit dem Gate des Thyristors (1) verbunden ist, dessen Kollektor mit einem positiven Anschluß der Spannungsversorgung (E) und dessen Basis mit dem Einschaltsignal-Eingangsanschluß (2) verbunden ist.

3. Schaltung nach Anspruch 2, bei der weiter ein Schaltelement ($Tr_1$) vorhanden ist, welches zwischen die Kathode des Thyristors (1) und den Einschaltsignal-Eingangsanschluß (2) geschaltet ist, wobei das Schaltelement ($Tr_1$) durch das Gate-Zündsignal ein- oder ausgeschaltet wird, und daß ein Widerstand ($R_1$) vorhanden ist, der zwischen den positiven Anschluß der Spannungsversorgung (E) und den Einschaltsignal-Eingangsanschluß (2) geschaltet ist.

4. Schaltung nach Anspruch 2, welche weiter eine Reihenschaltung aufweist, bei der ein Schaltelement ($Tr_3$) in Reihe mit einem Widerstand ($R_1$) geschaltet ist, wobei die Reihenschaltung zwischen den positiven Anschluß der Spannungsversorgung (E) und den Einschaltsignal-Eingangsanschluß (2) gelegt ist, wobei das Schaltelement ($Tr_3$) durch das Gate-Zündsignal ein- oder ausgeschaltet wird.

5. Thyristor mit einer Schaltung nach irgendeinem der voranstehenden Ansprüche.

6. Thyristor nach Anspruch 5, welcher ein über das Gate abschaltbarer Thyristor ist.

**Revendications**

1. Circuit de commande de gâchette pour un thyristor comprenant une alimentation en courant (E) pour appliquer un courant de mise en circuit de la gâchette à travers une gâchette et une cathode du thyristor (1) et un circuit de commutation ($Tr_2$) connecté en série avec l'alimentation en courant (E) pour mettre en circuit ou hors circuit le courant de mise en circuit de la gâchette, caractérisé en ce qu'une diode ($D_1$) est connectée entre une borne d'entrée (2) du signal de mise en circuit dudit circuit de commutation ($Tr_2$) et l'anode dudit thyristor (1) avec la direction directe de la diode ($D_1$) vers l'anode du thyristor (1) afin de rendre ledit circuit de commutation ($Tr_2$) non conducteur quand le thyristor (1) a été mis en circuit par le courant de mise en circuit de la gâchette.

2. Circuit de commande de gâchette selon la revendication 1 où ledit circuit de commutation est un transistor ($Tr_2$) dont l'émetteur est connecté à la gâchette dudit thyristor (1), dont le collector est connecté à une borne positive de ladite alimentation courant (E) et dont la base est connectée à ladite borne d'entrée (2) du signal de mise en circuit.

3. Circuit de commande de gâchette selon la revendication 2, comprenant de plus un élément de commutation ($Tr_1$) connecté entre la cathode du thyristor (1) et la borne d'entrée (2) du signal de mise en circuit, ledit élément de commutation ($Tr_1$) étant mis en circuit ou hors circuit par le signal d'allumage de gâchette, et il y a une résistance ($R_1$) connectée entre la borne positive de ladite alimentation courant (E) et ladite borne d'entrée (2) du signal de mise en circuit.

4. Circuit de commande de gâchette selon la revendication 2, comprenant de plus un circuit en série dans lequel un élément de commutation ($Tr_3$) est connecté en série avec une résistance ($R_1$), ledit circuit en série étant disposé entre la borne positive de l'alimentation en courant (E) et la borne d'entrée de signaux de mise en circuit (2), ledit élément de commutation ($Tr_3$) étant mis en circuit ou hors circuit par le signal d'allumage de gâchette.

5. Thyristor ayant un circuit de commande de gâchette selon l'une quelconque des revendications précédentes.

6. Thyristor selon la revendication 5 qui est un thyristor mis hors circuit par la gâchette.

**FIG. 1**

# FIG. 2